# EUROPEAN PATENT APPLICATION

(11) **EP 1 715 079 A1**
(43) Date of publication of application: **25.10.2006**
(21) Application number: 04807927.1
(22) Date of filing: 27.12.2004
(51) Int. Cl.: C23C 16/34, H01L 21/28, H01L 21/285

(54) **DEPOSITION OF TITANIUM NITRIDE FILM**

(30) Priority: 26.12.2003 JP 2003434860
(71) Applicant: Tokyo Electron Ltd., Tokyo 107-8481 (JP)
(72) Inventor: MURAKAMI, Seishi, c/o Tokyo Electron AT Limited, Nirasaki-shi, Yamanashi 4070192 (JP); TADA, Kunihiro, c/o Tokyo Electron AT Limited, Nirasaki-shi, Yamanashi 4070192 (JP)
(74) Representative: Liesegang, Eva
(86) International application number: PCT/JP2004/019572
(87) International publication number: WO 2005/064041

(57) **Abstract**

Disclosed is a method of forming a titanium nitride film on a substrate through the reaction of titanium tetrachloride and ammonia while minimizing corrosion of the underlying layer. A first titanium nitride layer is formed on a substrate by reacting titanium tetrachloride and ammonia with each other in the supply-limited region while minimizing corrosion of the underlying layer. Thereafter, a second titanium nitride layer is formed on the first titanium nitride layer in the reaction-limited region while achieving good step coverage.

## Description

### TECHNICAL FIELD

The present invention relates to a method of forming a titanium nitride film on a substrate to be processed through the reaction of tetrachloride (TiCl₄) and ammonia (NH₃).

### BACKGROUND ART

JP2000-68232A discloses a method of forming a TiN film while changing TiCl₄/ NH₃ flow rate ratio. In this method, however, as the TiCl₄/NH3 flow rate ratio is not proper, the underlying layer is likely to be etched due to Cl or HCl produced from TiClx (x=1 to 4) during the film formation. In the event that the underlying layer is etched: if the underlying layer is a conductive layer, the TiN film is separated from the conductive layer, resulting in increase of the contact resistance; if the underlying layer is a dielectric layer, the dielectric capacity is decreased, resulting in deterioration of device property of the element.

### DISCLOSURE OF THE INVENTION

The object of the present invention is to provide a film-forming technique that solves the foregoing problem.

The objective can be achieved by the inventions defined in the independent claims. The dependent claims define advantageous concrete embodiments of the present invention.

In order to solve the foregoing problem, according to the first aspect of the present invention, there is provide a film-forming method of forming a titanium nitride film on a substrate to be processed through reaction of titanium tetrachloride and ammonia, the method including: a first step of reacting titanium tetrachloride and ammonia with each other in supply-limited region, thereby forming a first titanium nitride layer on the substrate; and a second step of reacting titanium tetrachloride and ammonia with each other in reaction-limited region, thereby forming a second titanium nitride layer on the first titanium nitride layer.

As the first titanium nitride film (layer) is formed under titanium tetrachloride supply-limited condition in the first step, the titanium tetrachloride concentration in the first titanium nitride layer thus formed and the concentration of corrosive gases such as chlorine gas and hydrochloride gas generated due to the reaction is very low. Thus, even if the underlying layer is formed of a material vulnerable to etching by a corrosive-gas, etching of the underlying layer can be suppressed in the first step. The underlying layer has been covered with the first titanium nitride film in the second step that forms the second titanium nitride film (layer). Therefore, even if the second titanium nitride film is formed under reaction-limited condition in the second step, etching of the underlying layer can be suppressed. Thus, according to the present invention, a titanium nitride film with good step coverage can be formed, while suppressing the etching of the underlying layer.

Preferably, partial pressure ratio of the titanium tetrachloride to the ammonia in the first step is higher than that in the second step. For example, the partial pressure ratio in the first step is not less than 0.13 but less than 0.2, and the partial pressure ratio in the second step is not less than 0.2 but less than 1.5.

Preferably, temperature of the substrate in the first step is lower than that in the second step. Preferably, the temperature of the substrate in the first step is lower than 400°C, and the temperature of the substrate in the second step is not lower than 400°C. Due to this, a titanium nitride film having a low electric resistance and having a lower chloride concentration can be formed, while suppressing the etching of the underlying layer.

The present invention further provides a film-forming method of forming a titanium nitride film on a substrate to be processed in a chamber through reaction of titanium tetrachloride and ammonia, the method including: a first step of supplying titanium tetrachloride and ammonia into the chamber with flow rate ratio of the titanium tetrachloride to the ammonia being a first flow rate ratio, while pressure in the chamber being maintained within a range of 3.94×10⁻⁴ to 1.32×10⁻² atm, thereby forming a first titanium nitride layer on the substrate; a second step of supplying titanium tetrachloride and ammonia into the chamber with flow rate ratio of the titanium tetrachloride to the ammonia being a second flow rate ratio smaller than the first flow rate ratio, while pressure in the chamber being maintained within a range of 3.94×10⁻⁴ to 1.32×10⁻² atm, thereby forming a second titanium nitride layer on the first titanium nitride layer.

According the second aspect of the present invention, there is provided a semiconductor device including a titanium nitride film formed by the foregoing methods.

According the third aspect of the present invention, there is provided a storage medium storing a software executable by a control computer of a film-forming apparatus, wherein upon execution of the software the control computer controls the film-forming apparatus so that the apparatus performs the foregoing film-forming methods of forming a titanium nitride film.

According the fourth aspect of the present invention, there is provided a film-forming system for forming a titanium nitride film on a substrate through reaction of titanium tetrachloride and ammonia, the system including: at least one film-forming apparatus including: a film-forming chamber; a substrate support member that supports a substrate in the film-forming chamber; a first supply line, provided thereon with a first gas flow controller, that supplies titanium tetrachloride into the film-forming chamber; a second supply line, provided thereon with a second gas flow controller, that supplies titanium ammonia into the film-forming chamber; and an exhaust device that evacuates an atmosphere in the film-forming chamber; and a control unit that controls said at least one of the film-forming apparatus so that the apparatus performs a first step of reacting titanium tetrachloride and ammonia with each other under supply-limited condition, thereby forming a first titanium nitride layer on the substrate, and a second step of reacting titanium tetrachloride and ammonia with each other under reaction-limited condition, thereby forming a second titanium nitride layer on the first titanium nitride layer.

### BRIEF DESCRIPTION OF THE DRAWINGS

Fig. 1 is a schematic diagram showing the structure of the film-forming system 100 of a multi-chamber type provided with a Ti film-forming apparatus and TiN film-forming apparatus that perform the film-forming method in one embodiment of the present invention;
Fig. 2 is a cross-sectional view of the TiN film-forming apparatus 3.
Fig. 3 shows other embodiments of a wafer elevating mechanism.
Fig. 4 is a flowchart illustrating the first embodiment of the TiN film-forming method;
Fig. 5 is a graph showing the growth rate of a TiN film with respect to the titanium tetrachloride partial pressure ratio;
Fig. 6 shows tables respectively showing the film-forming conditions of the first TiN film and the second TiN film;
Fig. 7 is a flowchart illustrating the second embodiment of the TiN film-forming method; and
Fig. 8 is a cross-sectional view showing a part of a semiconductor device including a first TiN film 24 and a second TiN film 25 formed according to the film-forming method in one embodiment of the present invention.

### DESCRIPTION OF THE PREFERRED EMBODIMENTS

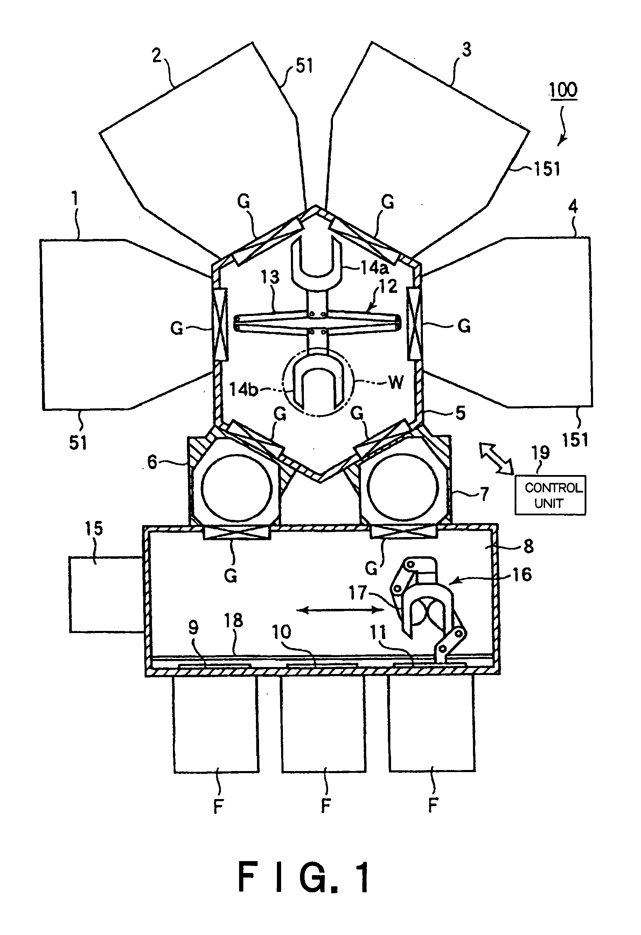

Preferred embodiments of the present invention will now be specifically described with reference to the accompanying drawings. Fig. 1 is a schematic diagram showing the configuration a film-forming system 100 of a multi-chamber type, including Ti film-forming apparatus TiN film-forming apparatus for performing a film-forming method according to the present invention. The film-forming system 100 includes four film-forming apparatuses: Ti film-forming apparatuses 1 and 2 for forming a Ti film by plasma CVD; and TiN film-forming apparatuses 3 and 4 for forming a TiN film by thermal CVD. The film-forming apparatuses 1, 2, 3, and 4 are respectively provided on four sides of a wafer transfer chamber 5 having a hexagonal cross section. Note that, although the film-forming system 100 in this embodiment includes the Ti film-forming apparatuses 1 and 2 and the TiN film-forming apparatuses 3 and 4, a dielectric film-forming apparatus may be substituted for the Ti film-forming apparatus 1 in another embodiment.

Load-lock chambers 6 and 7 are provided on the remaining two sides of the wafer transfer chamber 5. A wafer carrying-in-and-out chamber 8 is provided on the sides of the load-lock chambers 6 and 7 opposite to the wafer transfer chamber 5. Provided on the side of the wafer carrying-in-and-out chamber 8 opposite to the load-lock chambers 6 and 7 are three ports 9, 10, and 11, to which three FOUPs, or wafer containers, each being capable of accommodating wafers W (a wafer W is an example of a substrate to be processed) therein, can be attached, respectively, and through which ports wafers W are carried into and out of the film-forming system 100.

Each of the Ti film-forming apparatuses 1 and 2 has a Ti film-forming chamber 51; and each of the TiN film-forming apparatuses 3 and 4 has a TiN film-forming chamber 151. The Ti film-forming chambers 51, the TiN film-forming chambers 151, and the load-lock chambers 6 and 7 are connected to respective sides of the wafer transfer chamber 5 through respective gate valves G, as shown in Fig. 1. The chambers 51, 151, 6 and 7 are communicated with the wafer transfer chamber 5 when their respective gate valves G are opened; while they are separated from the wafer transfer chamber 5 when these gate valves G are closed. Gate valves G are also arranged at the joint between the load-lock chambers 6, 7 and the wafer carrying-in-and-out chamber 8 through respective gate valves G. The load-lock chambers 6 and 7 are communicated with the wafer carrying-in-and-out chamber 8 when these gate valves are opened; they are separated from the wafer carrying-in-and-out chamber 8 when these gate valves are closed.

The wafer transfer chamber 5 is provided therein with a wafer transfer device 12 to transfer a wafer W to be processed to and from the Ti film-forming apparatuses 1 and 2, the TiN film-forming apparatuses 3 and 4 and the load-lock chambers 6 and 7. The wafer transfer device 12 is disposed approximately at the center of the wafer transfer chamber 5, and includes a rotatable-and-retractable part 13 which is provided on its tips with two blades 14a and 14b each for holding a wafer W. The blades 14a and 14b are attached to the rotatable-and-retractable part 13 such that they face in opposite directions. The blades 14a and 14b can be projected and retracted independently and simultaneously. The interior of the wafer transfer chamber 5 can be maintained at a predetermined degree of vacuum.

A HEPA filter (not shown) is provided on the ceiling portion of the wafer carrying-in-and-out chamber 8. Clean air passed through the HEPA filter supplied into the wafer carrying-in-and-out chamber 8 flows downward therein, which allows a wafer W to be transferred into and from the wafer carrying-in-and-out chamber 8 of a clean-air atmosphere of atmospheric pressure. A shutter (not shown) is provided on each of the three ports 9, 10, and 11, each for holding a FOUP, of the wafer carrying-in-and-out chamber 8. When a FOUP F accommodating wafers W or an empty FOUP F is attached to one of the port, the shutter is opened so that the interior of the FOUP is communicated with the wafer carrying-in-and-out chamber 8 while preventing ambient-air entry. An alignment chamber 15, in which a wafer W is aligned, is provided on a side of the wafer carrying-in-and-out chamber 8.

A wafer transfer device 16 is arranged in the wafer carrying-in-and-out chamber 8 to transfer a wafer W to and from the FOUP F and the load-lock chambers 6 and 7. The wafer transfer device 16 has an articulated arm structure and can be moved on a rail 18 in the direction in which the FOUPs F are arrayed. The wafer transfer device 16 transfers a wafer W while holding it on the hand 17 provided at the tip of the an articulated arm structure.

A control unit 19 controls the operation of the entire system, such as the operations of the wafer transfer devices 12 and 16, etc.

In the foregoing film-forming system 100, first, the wafer transfer device 16, which is arranged in the wafer carrying-in-and-out chamber 8 providing a clean-air atmosphere of atmospheric pressure therein, removes a wafer W from one of the FOUPs and transfers it to the alignment chamber 15, in which the wafer W is aligned. Thereafter, the wafer W is transferred to either the load-lock chamber 6 or 7; after the load-lock chamber is evacuated, the wafer transfer device 12 in the wafer transfer chamber 5 transfers the wafer W from the load-lock chamber to the Ti film-forming chamber 51 of the Ti film-forming apparatus 1 or 2, in which the Ti film-forming process is performed. Thereafter, the wafer W having been subjected to the Ti film-forming process is subsequently loaded into the Ti film-forming chamber 151 of the TiN film-forming apparatus 3 or 4, in which the TiN film-forming process is performed. That is, the Ti film-forming process and the TiN film-forming process are sequentially performed, in-situ. Thereafter, the wafer transfer device 12 transfers the wafer W having been subjected to the film-forming processes to the load-lock chamber 6 or 7. Then, after the load-lock chamber is brought back to atmospheric pressure, the wafer transfer device 16 in the wafer carrying-in-and-out chamber 8 removes the wafer W from the load-lock chamber and returns it to one of the FOUPs F. The above operations are performed repeatedly to wafers W of one process lot, completing a set of film-forming processes.

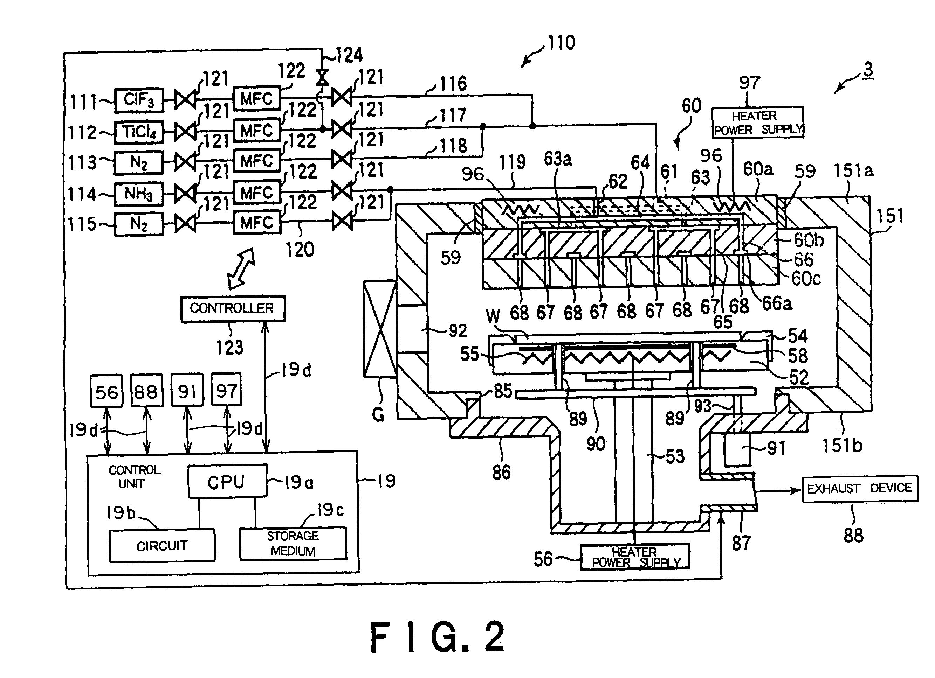

Fig. 2 is a cross-sectional view of the TiN film-forming apparatus 3. The TiN film-forming apparatuses 3 and 4 have the same structure, and thus only the structure of the TiN film-forming apparatus 3 will be described hereinafter. The TiN film-forming apparatus 3 has the TiN film-forming chamber 151 as mentioned above. The TiN film-forming chamber 151 is a hermetically-sealed, cylindrical chamber, in which a susceptor 52 for supporting a wafer W horizontally is arranged with the susceptor 52 being supported by a cylindrical support member 53 arranged below the susceptor 52.

The susceptor is made of a ceramic material such as AIN, and provided at the periphery thereof with a guide ring 54. A heater 55 is embedded in the susceptor 52. The heater 55 heats the wafer W up to a predetermined temperature when it is supplied with electric power by the heater power supply 56. An electrode 58 that functions as a lower electrode is embedded in the susceptor 52 above the heater 55.

A shower head 60 is attached to a ceiling wall 151a of the chamber 151 through an insulating member 59. The shower head 60 includes an upper block 60a, a middle block 60b and a lower block 60c. A ring-shaped heater 96 is embedded in the peripheral portion of the lower block 40c. The heater 96 receives power from a heater power supply 97, whereby the heater 96 is capable of heating the shower head 60 up to a predetermined temperature.

Discharge holes 67 and discharge holes 68 are alternately formed in the lower block 60c to discharge a gas therefrom. A first gas introduction port 61 and a second gas introduction port 62 are formed in the upper surface of the upper block 60a. A number of gas passages 63 branch off from the first gas introduction port 61 in the upper block 60a. Gas passages 65 are formed in the middle block 60b. The gas passages 63 are connected to the gas passages 65 through communication passages 63a. A number of gas passages 64 branch off from the second gas introduction port 62 in the upper block 60a. Gas passages 66 are formed in the middle block 60b. The gas passages 64 are connected to the gas passages 66. The gas passages 66 are connected to communication passages 66a horizontally extending in the middle block 60b, and the communication passages 66a are connected to the discharge holes 68 formed in the lower block 68.

The gas supply mechanism 110 includes: a ClF₃ gas supply source 111 for supplying ClF₃ gas as a cleaning gas; a TiCl₄ gas supply source 112 for supplying TiCl₄ gas as a Ti-containing gas; a first N₂ gas supply source 113 for supplying N₂ gas; an NH₃ gas supply source 114 for supplying NH₃ gas as a nitriding gas; and a second N₂ gas supply source 115 for supplying N₂ gas. A ClF₃ gas supply line 116 is connected to the ClF₃ gas supply source 111; a TiCl₄ gas supply line 117 is connected to the TiCl₄ gas supply source 112; a first N₂ gas supply line 118 is connected to the first N₂ gas supply source 113; an NH₃ gas supply line 119 is connected to the NH₃ gas supply source 114. The gas supply mechanism 110 further includes an Ar gas supply source, not shown. A mass flow controller 122 and two valves 121 arranged on opposite sides of the mass flow controller 122 are provided in each gas supply line. A pre-flow line 124 is connected to the TiCl₄ gas supply line 117.

The TiCl₄ gas supply line 117 extending from the TiCl₄ gas supply source 112 is connected to the first gas introduction port 61 of the shower head 60. The ClF₃ gas supply line 116 extending from the ClF₃ gas supply source 111 and the first N₂ gas supply line 118 extending from the first N₂ gas supply source 113 are connected to the TiCl₄ gas supply line 117. The NH₃ gas supply line 119 extending from the NH₃ gas supply source 114 is connected to the second gas introduction port 62. The second N₂ gas supply line 120 extending from the first N₂ gas supply source 115 is connected to the NH₃ gas supply line 119. Therefore, during film-forming process, TiCl₄ gas supplied from the TiCl₄ gas supply source 112 is supplied through the TiCl₄ gas supply line 117 into the shower head 60 through the first gas introduction port 61 together with N₂ gas supplied from the first N₂ gas supply source 113, and passes through the gas passages 63 and 65 to be discharged into the TiN film-forming chamber 151 through the discharge ports 67; while NH₃ gas as a nitriding gas supplied from the NH₃ gas supply source 114 is supplied through the NH₃ gas supply line 119 into the shower head 60 through the second gas introduction port 62 together with N₂ gas supplied from the second N₂ gas supply source 114, and passes through the gas passages 64 and 66 to be discharged into the TiN film-forming chamber 151 through the discharge ports 68. That is, the shower head 60 is of a post-mix type which supplies TiCl₄ gas and NH₃ gas separately into the TiN film-forming chamber 151, and hence these gases are mixed and react with each other after they are discharged. The valves 121 and the mass flow controllers 122 are controlled by a controller 123.

A circular hole 85 is formed in the center portion of a bottom wall 151b the TiN film-forming chamber 151; and an exhaust chamber 86 is attached to the bottom wall 151b such that the exhaust chamber 86 protrudes downward and covers the hole85. An exhaust pipe 87 is connected to the side of the exhaust chamber 86. An exhaust device 88 is connected to the exhaust pipe 87. Thus, the interior of the TiN film-forming chamber 151 can be uniformly evacuated to a predetermined vacuum via the exhaust chamber 86 by operating the exhaust device 88.

Three wafer support pins 89 (only two of which are shown) for supporting and for elevating and lowering the wafer W penetrate through the susceptor 52. The wafer support pins 89 are fixed to a support member 90, and are raised and lowered by a drive mechanism 91 (e.g., a motor) through the support member 90 and a support rod 93 supporting the support member 90. The support pins 89, support member 90 and/or a support rod 93 may be formed of a ceramic material such as Al₂O₃, or quartz.

In a case where the surface of a film formed on the susceptor 52 is likely to take (electric) charge such as a case where plasma is used for the film formation or a case where a reaction gas that likely to charge such as chlorine-containing gas is used, it is preferable that at least the surface of each wafer support pin 89 is formed of an electrically-conductive material. Preferably, the electrically-conductive material is one having a high corrosion resistance against cleaning gases, such as nickel (Ni) or HASTELLOY (trademark). The electrically-conductive material may be a ceramic material having electrical conductivity. If at least the surface of each wafer support pin 89 is formed of an electrically-conductive material, the wafer support pin 89 is preferably configured to be connected to ground when the wafer support pin 89 is in contact with the wafer W.

A carrying-in-and-out port 92 and a gate valve G for opening and closing the carrying-in-and-out port 92 are provided in a side wall of the TiN film-forming chamber 51. Note that, in this embodiment, a radio-frequency power source is connected to an upper part of the TiN film-forming chamber 51, and thus the TiN film-forming chamber 51 is a chamber of a plasma CVD apparatus. Except for this point, the TiN film-forming chamber 51 has the same structure as the TiN film-forming chamber 151.

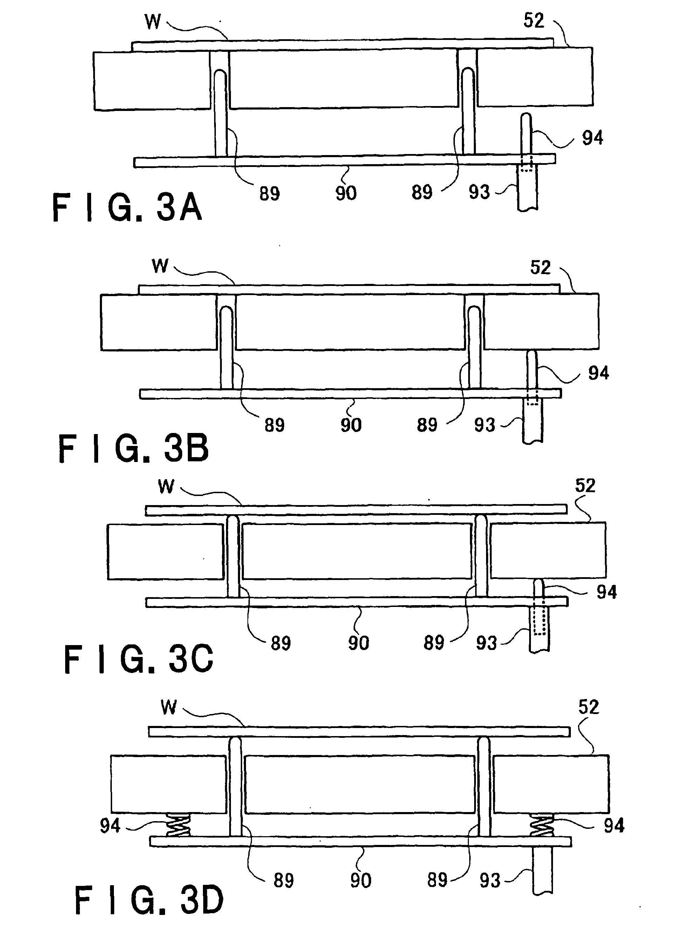

Fig. 3 shows other embodiments of a wafer elevating mechanism. In this embodiment, the wafer elevating mechanism comprises wafer support pins 89, a support member 90, a support rod 93 and a charge-removing pin 94. The wafer support pins 89 and a support member 90 are formed of a ceramic material such as Al₂O₃ or aluminum nitride (AIN), or a quartz material. At least the surface of each of the support rod 93 and the charge-removing pin 94 may be formed of an electrically-conductive material such as Ni or a Ni alloy, e.g., HASTELLOY. The charge-removing pin 94 is arranged so that a part thereof can contact to the susceptor 52, and is configured to be connected to ground at least when the charge-removing pin 94 is in contact with the susceptor 52. It is preferable that the charge-removing pin 94 is arranged such that it contacts to a surface of the susceptor 52 opposite to the surface of the susceptor 52 on which the wafer W is placed. It is also preferable that at least the surface of each of the wafer support pins 89 and the support member 90 is formed of an electrically-conductive material, and is electrically connected to the charge-removing pins 94.

In the embodiment shown (a) to (c) of Fig. 3, the charge-removing pin 94 can retract into the support rod 93. The charge-removing pin 94 is constructed so that a part thereof can protrude from the support member 90 in the raising-and-lowering direction of the wafer support pins 89. The charge-removing pin 94 is preferably arranged such that, when the charge-removing pin 94 is not in contact with the susceptor 52, the gap between the charge-removing pin 94 and the susceptor 52 is smaller than the gap between each wafer support pin 89 and the wafer W. That is, the charge-removing pin 94 is preferably arranged such that, when moving the wafer support pins 89 to approach the wafer W, the charge-removing pin 94 comes into contact with the susceptor 52 before the wafer support pins 89 comes into contact with the wafer W.

The charge-removing pin 94 is arranged such that, when the charge-removing pin 94 is subjected to a force that moves the charge-removing pin 94 into the support rod 93, the charge-removing pin 94 moves into the support rod 93, but when the force is released, the charge-removing pin 94 protrudes from the support rod 93. In an illustrative embodiment, the charge-removing pin 94 is held in the support rod 93 via an elastic member.

Next, the operation of the wafer elevating mechanism will be described. At the time of the completion of the TiN film on the wafer W, the wafer support pins 89 and the charge-removing pin 94 are spaced at respective distances from the wafer W and the susceptor 52, respectively (Fig. 3(a)). That is, the wafer support pins 89 and the charge-removing pin 94 are not in contact with wafer W and the susceptor 52, respectively.

As the driving mechanism 91 moves the wafer support pins 89 so that they approach the wafer W, the charge removing pin 94 firstly comes into contact with the susceptor 52 (Fig. 3(b)). A TiN film is formed on the surface of the susceptor 52 when a TiN film is formed on the wafer W. An electric charge accumulated in the susceptor 52 and the wafer W is removed through the charge-removing pin 94 which is connected to ground. As the driving mechanism 91 further moves the wafer support pins 89 in the same direction, the wafer support pins 89 come into contact with the wafer W, and subsequently lift the wafer W off the susceptor 52 (Fig. 3(c)).

In the embodiment shown in Fig. 3(d), the charge-romoving pin 94 is formed of an elastic material. The charge-removing pin 94 may be formed of an electrically-conductive material having elasticity. The charge-removing pin 94 may also be formed in a shape having spring property such as a shape of a coil spring as illustrated. The illustrated charge-removing pin 94 has spring property with respect to the raising-and-lowering direction of the wafer support pins 89, and is arranged on the support member 90.

Also in the embodiment shown in Fig. 3 (d), the charge-removing pin 94 is preferably arranged such that, when the charge-removing pin 94 is not in contact with the susceptor 52, the gap between the charge-removing pin 94 and the susceptor 52 is smaller than the gap between each wafer support pin 89 and the wafer W. The wafer elevating mechanism shown in Fig. 3(d) operates in the same manner as that of the wafer elevating mechanism shown in (a) to (c) of Fig. 3.

According to the embodiments shown in Fig. 3, the electric charge accumulated in the susceptor 52 can be discharged therefrom by contacting the charge-removing pin 94, connected to ground, to the susceptor 52. Thus, the difference of the electric potential between the wafer W and the susceptor 52, or between the TiN film on the susceptoer 52 and the wafer W can be reduced to a very low level. Accordingly, electrostatic discharge failure of the elements formed on the wafer W can be prevented.

Referring again to Fig. 2, the control unit 19, which controls the whole operations of the film-forming system 100, is embodied as a control computer which includes a central processing unit (CPU) 19a; a circuit 19b that supports the CPU 19a; a storage medium 19c storing control software. The control unit 19 controls all the functional elements (e.g., the heater power supply 56, the exhausting device 88, driving mechanism 91, the heater power supply 91, the valves 121, the mass-flow controllers 122) of the TiN film-forming apparatus 3 through signal lines 19d (only some of them are illustrated) in order to achieve various process conditions (e.g., process gas flow rate, process pressure, process temperature) defined by a process recipe.

The storage medium 19c may be one fixedly mounted to the control computer, or one detachably loaded to a reader mounted to the control computer and readable by the reader. In the most typical embodiment, the storage medium 19c is a hard disk drive in which the control software including a process recipe is installed by a service person of the manufacturer of the film-forming system 100. In another embodiment, the storage medium 19c is a removable disk such as a CD-ROM or a DVD-ROM. Such a removable disk is read by an optical reader mounted to the control computer. The storage medium 19c may be a ROM type or a RAM type. The storage medium 19c may be a cassette ROM. It should be noted that any storage medium known in the computer art can be used as the storage medium 19a. In a factory equipped with plural film-forming systems 100, the control software may be installed in a managing computer that manages the control computers (control units 19) of the film-forming systems 100 in an integrated fashion. In this case, each of the film-forming system is controlled by the managing computer through a communication line to perform a predetermined process.

Next, the method of forming a TiN film according to the present invention will be described. The description will be made for an example in which the TiN film-forming apparatus 3 forms a TiN film on a wafer W after the Ti film-forming apparatus 1 or 2 forms a Ti film on the wafer W. Preferably, the below-described method is automatically performed based on a process schedule and a process recipe stored in the storage medium 19c in the control computer (control unit) 19.

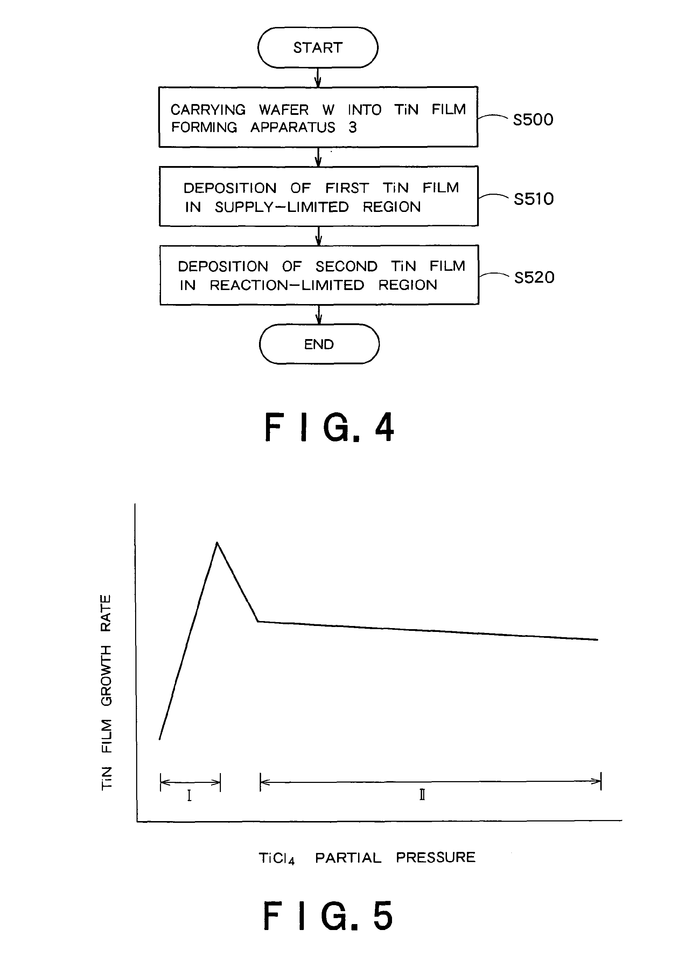

Fig. 4 is a flowchart illustrating the first embodiment of the TiN film-forming method. After a Ti film is formed on a wafer W in the Ti film-forming apparatus 1 or 2, the wafer transfer device 12 carries the wafer W from the Ti film-forming apparatus 1 or 2 into the wafer transfer chamber 5. The exhausting device 88 evaluates the interior of the TiN film-forming chamber 151 so that pressure in the TiN film-forming chamber 151 be at a predetermined value. Then, the gate valve G is opened, and the wafer transfer device 12 carries the wafer from the wafer transfer chamber 5 into the TiN film-forming chamber 151 through the carrying-in-and-out port 92 (STEP 500).

Then, N₂ gas and NH₃ gas is supplied into the TiN film-forming chamber 151, while the wafer W is preheated by the heater 5. After the temperature of the heated wafer W has been substantially stabilized at a predetermined value and pre-flowing of TiCl₄ gas through the pre-flow line 124 has been performed, TiCl₄ gas, NH₃ gas are N₂ gas supplied into the TiN film-forming chamber 151 through the TiCl₄ gas supply line 177, the valves 121, and N₂ gas supply lines 118 and 120, respectively. The flow rate of the TiCl₄ gas and the NH₃ gas are determined such that the reaction between the TiCl₄ gas and the NH₃ gas on the wafer W occurs under the supply-limited condition (i.e., the condition under which the deposition rate is limited by the supply rates of the gases). In other words, the partial pressure ratio of the TiCl₄ gas to the NH₃ gas is set so that the TiCl₄ gas and the NH₃ gas react with each other in the supply-limited region. Thus, a first TiN film is formed on the Ti film formed on the wafer W through the reaction between the TiCl₄ gas and the NH₃ gas on the wafer W heated up to the predetermined temperature (STEP 510).

In this embodiment, the flow rate ratio NH₃/TiCl₄ (i.e., the flow rate ratio of the NH₃ gas to the TiCl₄ gas) is set to be 60 or below such that the reaction rate of the TiCl₄ gas and the NH₃ gas on the wafer W is limited by the supply of the gases. The flow rate ratio NH₃/TiCl₄ is preferably in a range of 2.5 to 15, more preferably, 5 to 7.5. In this case, the flow rate of the TiCl₄ gas is preferably in a range of 6 to 18 sccm, while the flow rate of the NH₃ gas is in a range of 45 to 90 sccm. The internal pressure of the TiN film-forming chamber 151 is in a range of 0.3 to 10 Torr (3.94×10⁻⁴ to 1.32×10⁻² atm), preferably in a range of 1 to 8 Torr (1.32×10⁻³ to 1.06×10⁻² atm). The temperature of the wafer W is in a range of 350 to 700 °C.

After forming the first TiN film, the first TiN film may be annealed with NH₃ gas, which is an example of a nitrogen-atom-containing gas, being supplied into the TiN film-forming chamber 151. For example, the flow rate of the NH₃ gas supplied into the TiN forming chamber 151 is in a range of 45 to 90 sccm. The internal pressure of the TiN film-forming chamber 151 is in a range of 0.3 to 10 Torr (3.94×10⁻⁴ to 1.32×10⁻² atm), preferably in a range of 1 to 8 Torr (1.32×10⁻³ to 1.06×10⁻² atm). The temperature of the wafer W is in a range of 350 to 700 °C, more preferably, in a range of 500 to 600°C. Thereby, the chlorine concentration in the first TiN film can be further reduced, and thus a TiN film having a low resistivity and an excellent barrier property can be obtained.

In this embodiment, the TiN film is annealed by using NH₃ gas as a nitrogen-containing gas. In another embodiment, nitrogen gas or monomethyl hydrazine gas may be used as a nitrogen-atom-containing gas. Alternatively, the TiN film may be annealed by using a hydrogen-atom-containing gas such as hydrogen gas. In this embodiment, the forming and the annealing of the TiN film is performed in the same chamber, the chamber 151. In another embodiment, the after forming the TiN film, the wafer may be transferred to another chamber to perform the annealing therein.

Next, the flow rates of the NH₃ gas to the TiCl₄ gas supplied into the TiN film-forming chamber 151 are changed such that the reaction between the TiCl₄ gas and the NH₃ gas on the wafer W occurs under the reaction-limited condition (i.e., the condition under which the deposition rate is limited by the reaction rate of the gases). In other words, the partial pressure ratio of the TiCl₄ gas to the NH₃ gas is set such that the TiCl₄ gas and the of the NH₃ gas react with each other in the reaction-limited region. In detail, the flow rates of the NH₃ gas to the TiCl₄ gas are set such that the partial pressure ratio in this step is higher than that in the step of forming the first TiN film (STEP 500). Thus, a second TiN film is formed on the first TiN film formed on the wafer W through the reaction between the TiCl₄ gas and the NH₃ gas on the wafer W heated up to the predetermined temperature (STEP 520). Preferably, the second TiN film is thicker than the first TiN film. Thereby, the chlorine concentration in the first TiN film can be further reduced, and thus a TiN film having a low resistivity and an excellent barrier property can be obtained.

In this embodiment, the flow rate ratio NH_{3/}TiCl₄ (i.e., the flow rate ratio of the NH₃ gas to the TiCl₄ gas) is set to be 16 or below such that the reaction rate of the TiCl₄ gas and the NH₃ gas on the wafer W is limited of the reaction of the gases. The flow rate ratio NH_{3/}TiCl₄ is preferably in a range of 0.3 to 10, more preferably, 0.7 to 5. In this case, the flow rate of the TiCl₄ gas is preferably in a range of 9 to 130 sccm, while the flow rate of the NH₃ gas is in a range of 45 to 90 sccm. The internal pressure of the TiN film-forming chamber 151 is in a range of 0.3 to 10 Torr (3.94×10⁻⁴ to 1.32×10⁻² atm), preferably in a range of 1 to 8 Torr (1.32×10⁻³ to 1.06×10⁻² atm), more preferably in a range of 1 to 5 Torr (1.32×10⁻³ to 6.6×10⁻³ atm). The temperature of the wafer W is in a range of 350 to 700 °C.

After forming the second TiN film, the supply of the TiCl₄ gas and the NH₃ gas, and the N₂ gas as a purge gas is supplied into the TiN film-forming chamber 151 at a predetermined flow rate in order to purge the TiN film-forming chamber 151 and to remove the gases remaining in the TiN film-forming chamber 151. After the TiN film-forming chamber 151 is purged, the second TiN film may be annealed by supplying N₂ gas and NH₃ gas into the TiN film-forming chamber 151. In this case, the second TiN film is preferably annealed under the same conditions as those for the annealing of the first TiN film.

Fig. 5 shows the growth rate of the TiN film with respect to the TiCl₄ partial pressure ratio. As shown in Fig. 5, as the partial pressure ratio of the TiCl₄ gas to the NH₃ gas is increased while keeping the flow rate of the NH₃ gas supplied into the TiN film-forming chamber 151 constant, the TiN film growth rate increases at a substantially-constant increasing rate if the TiCl₄ partial pressure ratio is in a low level (Range I in Fig. 5). That is, the TiN film growth rate increases in proportion to the TiCl₄ partial pressure ratio. In this embodiment, the first TiN film is formed by supplying the TiCl₄ gas and the NH₃ gas into the TiN film-forming chamber 151 at respective flow rates which results in the partial pressure ratio of TiCl₄ gas to the NH₃ gas being within the Range I.

If the TiCl₄ partial pressure is increased beyond the Range I, the TiN film growth rate decreases at a substantially-constant increasing rate in proportion to the TiCl₄ partial pressure ratio. If the TiCl₄ partial pressure ratio is further increased, the TiN film growth rate (deposition rate) is substantially constant regardless of the TiCl₄ partial pressure ratio (Range II in Fig. 5). In this embodiment, the second TiN film is formed by supplying the TiCl₄ gas and the NH₃ gas into the TiN film-forming chamber 151 at respective flow rates which results in the partial pressure ratio of TiCl₄ gas to the NH₃ gas being within the Range II.

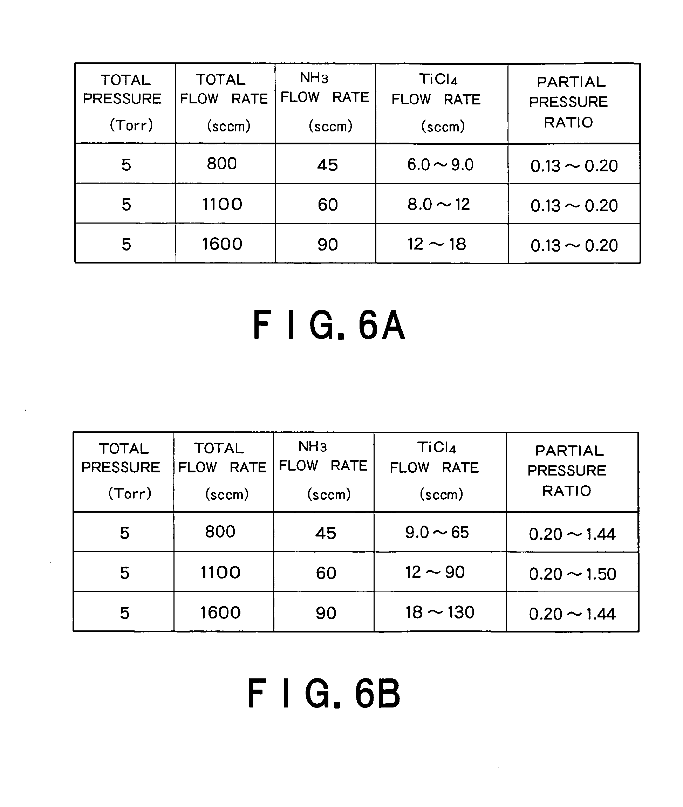

Fig. 6 includes tables illustrating examples of preferable film-forming conditions. Fig. 6(a) shows film-forming conditions for the first TiN film; and Fig. 6 (b) shows film-forming conditions for the second TiN film.

As shown in Fig. 6(a), the first TiN film is preferably formed by supplying the TiCl₄ gas and the NH₃ gas into the TiN film-forming chamber 151 while the partial pressure ratio of TiCl₄ gas to the NH₃ gas is maintained within a range of 0.13 to 0.20. In this case, the control unit 190 preferably controls the total pressure in the TiN film-forming chamber 151 at about 5 Torr (6.58×10⁻³ atm).

As shown in Fig. 6(b), the first TiN film is preferably formed by supplying the TiCl₄ gas and the NH₃ gas into the TiN film-forming chamber 151 while the partial pressure ratio of the TiCl₄ gas to the NH₃ gas is maintained at a range of 0.20 to 1.50. Also in this case, the control unit 190 preferably controls the total pressure in the TiN film-forming chamber 151 at about 5 Torr (6.58×10⁻³ atm).

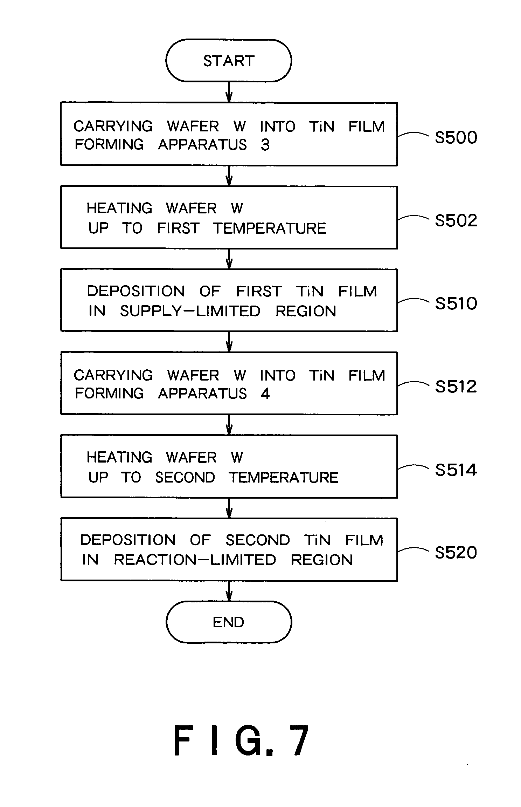

Fig.7 is a flowchart illustrating the second embodiment of the TiN film-forming method. In this embodiment, the temperature of the wafer when forming the first TiN film is lower than that when forming the second TiN film. In addition, the film-forming method in this embodiment forms the first TiN film in a TiN forming apparatus (chamber), and thereafter forms the second TiN film in another TiN forming apparatus. The TiN film-forming method in this embodiment will be described with reference to the flowchart.

First, the wafer transfer device 12 carries the wafer W from the wafer transfer chamber 5 through the carrying-in-and-out port 92 into the TiN film-forming chamber 151 of the TiN film-forming apparatus 3 (STEP 500). Then, N₂ gas and NH₃ gas is supplied into the TiN film-forming chamber 151, while the wafer W is preheated by the heater 55 (STEP 502). The wafer is preferably heated up to a temperature in a range of 200 to 400 °C, more preferably in a range of 300 to 400 °C. After the temperature of the heated wafer W has been substantially stabilized at a predetermined value, the first TiN film is formed on the wafer W through the reaction between the TiCl₄ gas and the NH₃ gas in the supply-limited region in the same manner as that in the first embodiment (STEP 510).

After forming the first TiN film on the wafer W, the wafer transfer device 12 removes the wafer W from the TiN film-forming apparatus 3, and carries it into the TiN film-forming chamber 151 of the TiN film-forming apparatus 4 (STEP 512). Then, N₂ gas and NH₃ gas is supplied into the TiN film-forming chamber 151, while the wafer W is preheated by the heater 55 (STEP 502). The wafer W is heated up to a temperature higher than the temperature of the wafer W when the first TiN film is formed, i.e., the temperature at which the wafer W is heated in the TiN film-forming apparatus 3. The wafer is preferably heated up to a temperature in a range of 400 to 700 °C, more preferably in a range of 450 to 600 °C. After the temperature of the heated wafer W has been substantially stabilized at a predetermined value, the second TiN film is formed on the wafer W through the reaction between the TiCl₄ gas and the NH₃ gas in the reaction-limited region in the same manner as that in the first embodiment (STEP 520).

Although the first TiN film and the second TiN film are formed in differenct TiN film-forming apparatuses in this embodiment, the first TiN film and the second TiN film may be formed in the same TiN film-forming apparatus while changing the temperature of the wafer W. In this case, the wafer W (or susceptor 52) is preferably heated by a lamp heater which enables rapid heating and/or cooling of the wafer W.

Although the TiN films are formed in the first TiN film-forming step and the second TiN film-forming step in the supply-limited region and the reaction-limited region, respectively, by controlling the flow rates of the TiCl₄ gas and the NH₃ gas in the foregoing embodiments, the TiN films may be formed in the supply-limited region and the reaction-limited region, respectively, by controlling another process parameter such as the pressure in the chamber or the temperature of the wafer W in another embodiment.

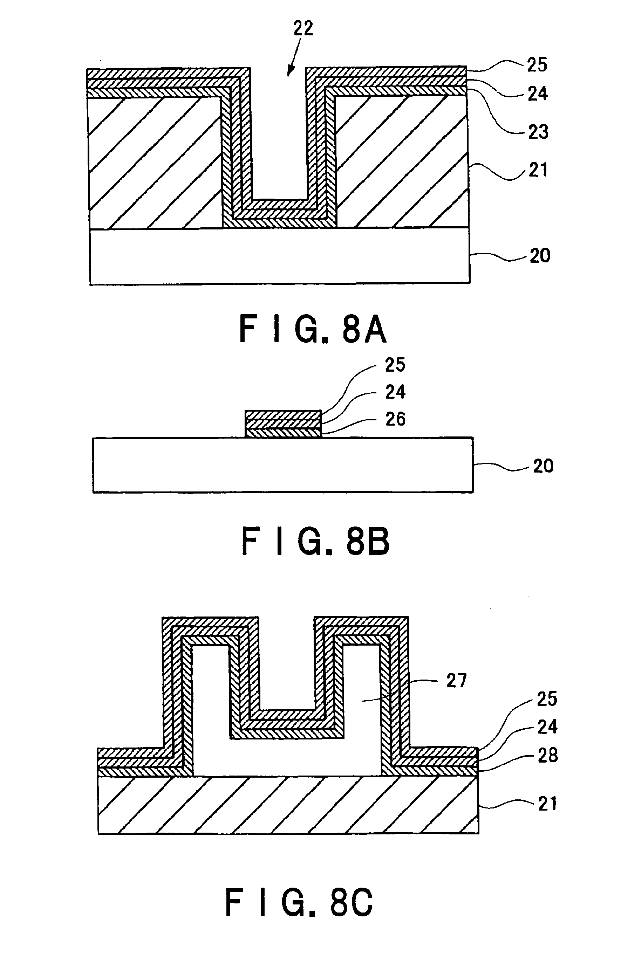

Fig. 8 shows parts of semiconductor devices having the first TiN film 24 and the second TiN film 25 formed by the film-forming method in the foregoing embodiments.

Fig. 8(a) is a cross-sectional view of a part of a semiconductor device having a contact hole 22. The illustrated semiconductor device comprises a underlying layer 20, an interlayer insulating film 21, the contact hole 22, Ti film 23, the first TiN film 24 and the second TiN film. The contact hole 22 is formed in the interlayer insulating film 22 to reach the underlying layer 21. The Ti film 23 serving as a contact layer to the underlying layer is formed on the inner surface of the contact hole 22 and on the upper surface of the interlayer insulating film 22. The first TiN film 24 and the second TiN film 25 serving as barrier layers are formed on the Ti film 23 according to the film-forming method in the foregoing embodiments. A film of a metal such as Al or W will be formed on the second TiN film 25 to form a wiring layer of the semiconductor device and to fill up the contact hole 22 with the metal. The underlying layer 22 may be formed of a metal, a semiconductor such as polycrystalline silicon, or a silicide such as cobalt silicide (CoSi) or nickel silicide (NiSi), for example.

Fig. 8(b) is a cross-sectional view showing a part of a semiconductor device having a field effect transistor. The illustrated semiconductor device comprises an underlying layer 20, a gate dielectric film 26, the first TiN film 24 and the second TiN film 25. The underlying layer 20 is a semiconductor layer in which a source, a drain and a channel are formed. The gate dielectric film 26 is formed on the channel. The first TiN film 24 and the second TiN film 25 are formed on the gate dielectric film 26 according to the film-forming method in the foregoing embodiments. It is preferable that the gate dielectric film 26 is formed of a high-k material such as hafnium oxide (HfO₂).

Fig. 8(c) is a cross-sectional view showing a part of a semiconductor device having a capacitor. The illustrated semiconductor device comprises: an interlayer insulating film 21; and a lower electrode 27, a capacitor dielectric film 28, the first TiN film 24 and the second TiN film 25 which constitute a capacitor. The lower electrode 27 is formed of an electrically-conductive material such as polycrystalline silicon, and is formed on the interlayer insulating film 21. The capacitor dielectric film is formed on the surfaces of the lower electrode 27 and the interlayer insulating film 26. The first TiN film 24 and the second TiN film 25 are formed on the dielectric film 28 according to the film-forming method in the foregoing embodiments.

The foregoing embodiments and applications explained in the foregoing description may be appropriately combined, varied or modified for various purposes. The present invention is not limited to the foregoing embodiments. It is apparent from the recitation of the claims that such combination, variation and modification can be within the technical scope of the present invention.

## Claims

1. A film-forming method of forming a titanium nitride film on a substrate to be processed through reaction of titanium tetrachloride and ammonia, said method comprising:
a first step of reacting titanium tetrachloride and ammonia with each other in supply-limited region, thereby forming a first titanium nitride layer on the substrate; and
a second step of reacting titanium tetrachloride and ammonia with each other in reaction-limited region, thereby forming a second titanium nitride layer on the first titanium nitride layer.

2. The film-forming method according to claim 1, wherein partial pressure ratio of the titanium tetrachloride to the ammonia in the first step is higher than that in the second step.

3. The film-forming method according to claim 2, wherein the partial pressure ratio of the titanium tetrachloride to the ammonia in the first step is not less than 0.13 but less than 0.2, and the partial pressure ratio of the titanium tetrachloride to the ammonia in the second step is not less than 0.2 but less than 1.5.

4. The film-forming method according to any one of claims 1 to 3, wherein temperature of the substrate in the first step is lower than that in the second step.

5. The film-forming method according to claim 5, wherein the temperature of the substrate in the first step is lower than 400°C, and the temperature of the substrate in the second step is not lower than 400°C.

6. A film-forming method of forming a titanium nitride film on a substrate to be processed in a chamber through reaction of titanium tetrachloride and ammonia, said method comprising:
a first step of supplying titanium tetrachloride and ammonia into the chamber with flow rate ratio of the titanium tetrachloride to the ammonia being a first flow rate ratio, while pressure in the chamber being maintained within a range of 3.94×10⁻⁴ to 1.32×10⁻² atm, thereby forming a first titanium nitride layer on the substrate;
a second step of supplying titanium tetrachloride and ammonia into the chamber with flow rate ratio of the titanium tetrachloride to the ammonia being a second flow rate ratio smaller than the first flow rate ratio, while pressure in the chamber being maintained within a range of 3.94×10⁻⁴ to 1.32×10⁻² atm, thereby forming a second titanium nitride layer on the first titanium nitride layer.

7. The film-forming method according to claim 6, wherein the first flow rate ratio is not less than 2.5 but not more than 60.

8. The film-forming method according to claim 6, wherein the first flow rate ratio is not less than 2.5 but not more than 15.

9. The film-forming method according to claim 6, wherein the first flow rate ratio is not less than 16, and the second flow rate is less than 16.

10. The film-forming method according to claim 9, wherein the second flow rate ratio is not less than 0.3 but not more than 10.

11. The film-forming method according to any one of claims 1 to 10, wherein the first and second titanium nitride layers are formed while the substrate is placed in the chamber in the first and second steps,
said method further comprising a step of purging an interior of the chamber with a purge gas after at least one of the first and second steps.

12. The film-forming method according to claim 11, wherein the purge gas comprises at least one of nitrogen gas, hydrogen gas and argon gas.

13. The film-forming method according to any one of claims 1 to 12, further comprising a step of annealing at least one of the first titanium nitride layer and the second titanium nitride layer with a gas containing nitrogen atoms or hydrogen atoms after at least one of the first and second steps.

14. The film-forming method according to claim 13, wherein the gas containing nitrogen atoms or hydrogen atoms contains at least one of ammonia gas, hydrogen gas, nitrogen gas and monomethyl hydrazine gas.

15. A semiconductor device including the titanium nitride film formed by the film-forming method according to any one of claims 1 to 14.

16. A storage medium storing a software executable by a control computer of a film-forming apparatus, wherein upon execution of the software the control computer controls the film-forming apparatus so that the apparatus performs a film-forming method of forming a titanium nitride film, said method comprising:
a first step of reacting titanium tetrachloride and ammonia with each other in supply-limited region, thereby forming a first titanium nitride layer on the substrate; and
a second step of reacting titanium tetrachloride and ammonia with each other in reaction-limited region, thereby forming a second titanium nitride layer on the first titanium nitride layer.

17. A storage medium storing a software executable by a control computer of a film-forming apparatus, wherein upon execution of the software the control computer controls the film-forming apparatus so that the apparatus performs a film-forming method of forming a titanium nitride film, said method comprising:
a first step of supplying titanium tetrachloride and ammonia into the chamber with flow rate ratio of the titanium tetrachloride to the ammonia being a first flow rate ratio, while pressure in the chamber being maintained within a range of 3.94×10⁻⁴ to 1.32×10⁻² atm, thereby forming a first titanium nitride layer on the substrate;
a second step of supplying titanium tetrachloride and ammonia into the chamber with flow rate ratio of the titanium tetrachloride to the ammonia being a second flow rate ratio smaller than the first flow rate ratio, while pressure in the chamber being maintained within a range of 3.94×10⁻⁴ to 1.32×10⁻² atm, thereby forming a second titanium nitride layer on the first titanium nitride layer.

18. A film-forming system for forming a titanium nitride film on a substrate through reaction of titanium tetrachloride and ammonia, said system comprising:
at least one film-forming apparatus including: a film-forming chamber; a substrate support member that supports a substrate in the film-forming chamber; a first supply line, provided thereon with a first gas flow controller, that supplies titanium tetrachloride into the film-forming chamber; a second supply line, provided thereon with a second gas flow controller, that supplies titanium ammonia into the film-forming chamber; and an exhaust device that evacuates an atmosphere in the film-forming chamber; and
a control unit that controls said at least one of the film-forming apparatus so that the apparatus performs a first step of reacting titanium tetrachloride and ammonia with each other in supply-limited region, thereby forming a first titanium nitride layer on the substrate, and a second step of reacting titanium tetrachloride and ammonia with each other in reaction-limited region, thereby forming a second titanium nitride layer on the first titanium nitride layer.
